(19) Europäisches Patentamt
European Patent Office
Office européen des brevets

(11) **EP 3 170 224 B1**

(12) **EUROPÄISCHE PATENTSCHRIFT**

(45) Veröffentlichungstag und Bekanntmachung des Hinweises auf die Patenterteilung:
**01.08.2018 Patentblatt 2018/31**

(21) Anmeldenummer: **15729161.8**

(22) Anmeldetag: **15.06.2015**

(51) Int Cl.:
*H01M 10/42* *(2006.01)*  *H01M 10/48* *(2006.01)*
*H01M 2/34* *(2006.01)*  *H01M 10/44* *(2006.01)*
*H02J 7/00* *(2006.01)*

(86) Internationale Anmeldenummer:
**PCT/EP2015/063315**

(87) Internationale Veröffentlichungsnummer:
**WO 2016/008661 (21.01.2016 Gazette 2016/03)**

(54) **SICHERER BETRIEB EINES ELEKTRISCHEN ENERGIESPEICHERS**

RELIABLE OPERATION OF AN ELECTRICAL ENERGY STORE

FONCTIONNEMENT EN TOUTE SÉCURITÉ D'UN ACCUMULATEUR D'ÉNERGIE ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.07.2014 AT 504942014**

(43) Veröffentlichungstag der Anmeldung:
**24.05.2017 Patentblatt 2017/21**

(73) Patentinhaber: **Siemens AG Österreich**
**1210 Wien (AT)**

(72) Erfinder: **ROTHWANGL, Heinz**
**A-1040 Wien (AT)**

(74) Vertreter: **Maier, Daniel Oliver**
**Siemens AG**
**Postfach 22 16 34**
**80506 München (DE)**

(56) Entgegenhaltungen:
**JP-A- 2008 228 429     JP-A- 2012 110 221**
**US-A- 5 909 103**

**Beschreibung**

Technisches Gebiet

Die Erfindung betrifft ein Verfahren zum sicheren Betrieb eines elektrischen Energiespeichers innerhalb eines vorgegebenen Spannungsbereiches mit einer minimalen und einer maximalen Energiespeicherspannung.

Stand der Technik

Elektrische Energiespeicher dürfen für einen sicheren Betrieb und zum Erhalt der Lebensdauer nur in gewissen Spannungsbereichen betrieben werden, weshalb bei Erreichen der Spannungsgrenzen diverse Vorkehrungen getroffen werden müssen, sodass der zulässige Spannungsbereich nicht über- oder unterschritten wird, wobei der Energiespeicher etwa mit Hilfe eines Tiefsetzstellers angesteuert wird.

Derzeitige Verfahren basieren darauf, mittels einer Steuerung den Energiespeicherstrom bei Erreichen der Spannungsgrenzen mittels einer zeitlichen Rampe gegen Null gehen zu lassen bzw. den Energiespeicherstrom sofort auf Null Ampere zu stellen. Dies ist mitunter mit abrupten Änderungen des Energiespeicherstroms verbunden, wodurch kurzzeitig die Spannung $U_D$ des Zwischenkreises auf hohe Werte ansteigen kann, sodass vorhandene Vorkehrungen zum Schutz des Zwischenkreises, wie zum Beispiel ein aktiver Zwischenkreisschutz (AZS), aktiv eingreifen müssen. Diese Vorkehrungen zum Schutz des Zwischenkreises werden auch benötigt, um zum Beispiel Netzspannungssprünge entsprechend beherrschen zu können.

Dokument US 2010/0259210A1 offenbart ein Verfahren zum Laden und Entladen eines elektrischen Energiespeichers, dessen Ladezustand sich zwischen zwei bestimmten Werten befinden soll.

Darstellung der Erfindung

Es ist daher eine Aufgabe der vorliegenden Erfindung, ein Verfahren zu schaffen, durch welches innerhalb eines vorgegebenen Spannungsbereichs ein sicherer Betrieb eines elektrischen Energiespeichers erreicht wird mit weniger abrupten Änderungen des Energiespeicherstroms bei Annäherung an die vorgegebene minimale oder maximale Energiespeicherspannung.

Diese Aufgabe wird durch ein Verfahren mit den Merkmalen des Patentanspruchs 1 gelöst, indem bei Annäherung an die vorgegebene minimale oder maximale Energiespeicherspannung $U_{ES,min}$, $U_{ES,max}$ des elektrischen Energiespeichers ein - dem Energiespeicher zugeordneter - Sollenergiespeicherstrom in Abhängigkeit der aktuellen Energiespeicherspannung durch einen aktuell minimalen und einen aktuell maximalen Energiespeicherstrom begrenzt wird.

Somit wird bei Annäherung an die Spannungsgrenzen des elektrischen Energiespeichers der Sollenergiespeicherstrom $I_{ES,soll}$ in Abhängigkeit der Energiespeicherspannung dynamisch mittels einer Regelung begrenzt.

Das heißt, dass mit Hilfe dieser Regelung der Sollenergiespeicherstrom $I_{ES,soll}$ durch den aktuell minimalen $I_{ES,min,akt}$ bzw. maximalen Energiespeicherstrom $I_{ES,max,akt}$ begrenzt wird, sodass gemäß Gl. 1 gilt:

$$I_{ES,min,akt} \leq I_{ES,soll} \leq I_{ES,max,akt} \qquad\qquad (1)$$

Es kann vorgesehen sein, dass für die Berechnung des aktuell minimalen Energiespeicherstroms $I_{ES,min,akt}$ eine Differenz zwischen der minimalen Energiespeicherspannung $U_{ES,min}$ und der aktuellen Energiespeicherspannung $U_{ES}$ gebildet wird, und/oder für die Berechnung des aktuell maximalen Energiespeicherstroms $I_{ES,max,akt}$ eine Differenz zwischen der maximalen Energiespeicherspannung $U_{ES,max}$ und der aktuellen Energiespeicherspannung $U_{ES}$ gebildet wird.

Durch die Differenzbildung wird bei Annäherung der aktuellen Energiespeicherspannung an die maximale bzw. minimale Energiespeicherspannung eine Einschleifregelung erreicht. Bei Erreichen der minimalen $U_{ES,min}$ oder der maximalen Energiespeicherspannung $U_{ES,max}$ durch die aktuelle Energiespeicherspannung $U_{ES}$ geht dann der Differenzwert $U_{ES,min}$ - $U_{ES}$ bzw. $U_{ES,max}$ - $U_{ES}$ gegen Null, wodurch der Sollstrom $I_{ES,soll}$ gegen Null begrenzt wird.

Der aktuell minimale Energiespeicherstrom $I_{ES,min,akt}$ kann durch Multiplikation des Differenzwerts ($U_{ES,min}$ - $U_{ES}$) mit einem konstanten Faktor $k_2$ und Subtraktion eines konstanten Offsetstroms $I_{ES,offset}$ vom Produkt gebildet werden, der aktuell maximale Energiespeicherstrom $I_{ES,max,akt}$ kann durch Multiplikation des Differenzwerts ($U_{ES,max}$ - $U_{ES}$) mit einem konstanten Faktor $k_1$ und Addition eines konstanten Offsetstromes $I_{ES,offset}$ zum Produkt gebildet werden.

Zur Gewährleistung, dass der aktuell minimale Energiespeicherstrom $I_{ES,min,akt}$ nicht kleiner als der negative maximale Energiespeicherstrom $I_{ES,max}$ ist und der aktuell maximale Energiespeicherstrom $I_{ES,max,akt}$ nicht größer als der positive maximale Energiespeicherstrom $I_{ES,max}$ ist, werden der aktuelle minimale bzw. maximale Energiespeicherstrom $I_{ES,min,akt}$ bzw. $I_{ES,max,akt}$ gemäß nachfolgender Gl. 2 und 3 ausgewählt:

$$I_{ES,max,akt} = \min\{I_{ES,max}; \ k_1 \ * \ (U_{ES,max} - U_{ES}) + I_{ES,offset}\}, \qquad (2)$$

$$I_{ES,min,akt} = \max\{-I_{ES,max}; \ k_2 \ * \ (U_{ES,min} - U_{ES}) - I_{ES,offset}\}, \qquad (3)$$

wobei $I_{Es,max}$ den maximal zulässigen Energiespeicherstrom darstellt und wobei die konstanten Faktoren $k_1$ bzw. $k_2$ eingesetzt werden, durch die, wenn die Energiespeicherspannung $U_{ES}$ den Minimal- $U_{ES,min}$ oder den Maximalspannungswert $U_{ES,max}$ erreicht, ein Term

$$k_1 \ * \ (U_{ES,max} - U_{ES}) \ bzw. \ k_2 \ * \ (U_{ES,min} - U_{ES}) \qquad (4)$$

und mit diesem Term der Sollenergiespeicherstrom $I_{ES,soll}$ gegen Null begrenzt wird.

Dabei ermöglicht der mit etwa 5% von $I_{ES,max}$ in der Regel relativ klein angesetzte positive Offsetstrom $I_{ES,offset}$ eine zügige Einschleifung auf den minimal bzw. maximal zulässigen Spannungswert. Grundsätzlich könnte der positive Offsetstrom $I_{ES,offset}$ im Bereich von 2-8% von $I_{ES,max}$ liegen.

Bei $I_{ES,offset} = 0A$ würde der Sollenergiespeicherstrom $I_{ES,soll}$ hingegen langsam gegen Null begrenzt werden und die Energiespeicherspannung gemäß einer Exponentialfunktion den maximal beziehungsweise minimal zulässigen Wert erreichen, was jedoch in der Theorie "unendlich" lange dauern würde.

Dadurch, dass der konstante Offsetstrom $I_{ES,offset} > 0A$ ist, wird erreicht, dass bei einer minimal bzw. maximal zulässigen Spannung noch immer mit dem Offsetstrom $I_{ES,offset}$ geladen bzw. entladen wird.

Somit wird bei Erreichen der minimalen oder der maximalen Energiespeicherspannung $U_{ES,min}$, $U_{ES,max}$ der Energiespeicher mit dem konstant positiven Offsetstrom $I_{ES,offset}$ entladen oder geladen.

Bei einer weiteren Erhöhung bzw. Verringerung beim Laden bzw. Entladen des Energiespeichers kann von der Regelung eine Impulssperre ausgegeben werden, wodurch der kleine Offsetstrom $I_{ES,offset}$ auf Null abgesenkt wird.

Diese Impulssperre bewirkt somit, dass bei der Entladung des Energiespeichers unter die minimale Energiespeicherspannung $U_{ES,min}$ oder bei der Überladung des Energiespeichers über die maximale Energiespeicherspannung $U_{ES,max}$ der Offsetstrom $I_{ES,offset}$ auf Null abgebaut wird.

Durch die konstanten Faktoren $k_1$ bzw. $k_2$ kann jene Energiespeicherspannung $U_{ES}$ festgelegt werden, bei der die Einschleifregelung entsprechend der Differenzwerte ($U_{ES,min}$ - $U_{ES}$) bzw. ($U_{ES,max}$ - $U_{ES}$) beginnt.

Die positiven Werte des Faktors $k_1 > 0$ bzw. $k_2 > 0$ bestimmen, ab wann die Einschleifregelung zu wirken beginnt. Zu Beginn der Einschleifregelung wird die Begrenzung durch den maximalen Energiespeicherstrom $I_{ES,max}$ durch den Term

$$k_1 \ * \ (U_{ES,max} - U_{ES}) + I_{ES,offset} \qquad (5)$$

abgelöst, wodurch gemäß Gl. 6 gilt:

$$k_1 \ * \ (U_{ES,max} - U_{ES}) + I_{ES,offset} = I_{ES,max} \qquad (6)$$

Analog gilt für die Einschleifregelung bei der Entladung:

$$k_2 \ * \ (U_{ES,min} - U_{ES}) - I_{ES,offset} = -I_{ES,max}$$

Die Einschleifregelung beginnt, wenn die Energiespeicherspannung $U_{ES}$ gleich einer Start-Energiespeicherspannung $U_{ES,startBeg1}$ zu Beginn ist, wodurch der konstante Faktor $k_1$ gemäß Gl. 10 berechnet wird:

$$k_1 * (U_{ES,max} - U_{ES,startBeg1}) + I_{ES,offset} = I_{ES,max} \qquad (7)$$

bzw:

$$k_1 = \frac{I_{ES,\max} - I_{ES,offset}}{U_{ES,\max} - U_{ES,StartBeg1}} \ . \qquad (8)$$

Analog gilt für den Faktor $k_2$:

$$k_2 * (U_{ES,\min} - U_{ES,StartBeg2}) - I_{ES,offset} \ = \ -I_{ES,\max} \qquad (9)$$

bzw. :

$$k_2 = \frac{I_{ES,offset} - I_{ES,\max}}{U_{ES,\min} - U_{ES,StartBeg2}} \qquad (10)$$

Im Allgemeinen wird dabei $U_{ES,startBeg1}$ gleich 98% von $U_{ES,\max}$ gesetzt bzw. wird $U_{ES,startBeg2}$ gleich 102% von $U_{ES,\min}$ gesetzt. $U_{ES,startBeg1}$ könnte aber in einem Bereich von 95-99% von $U_{ES,\max}$ liegen bzw. könnte $U_{ES,startBeg2}$ in einem Bereich von 101-105% von $U_{ES,\min}$ liegen.

Kurzbeschreibung der Figuren

Zur weiteren Erläuterung der Erfindung wird im nachfolgenden Teil der Beschreibung auf die Figur Bezug genommen, aus der weitere vorteilhafte Ausgestaltungen, Einzelheiten und Weiterbildungen der Erfindung zu entnehmen sind. Dabei zeigt:

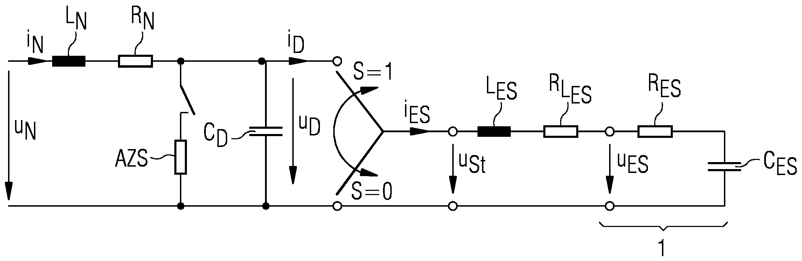

Fig. 1    einen Schaltungsaufbau eines elektrischen Energiespeichers mit einer Drossel zum sicheren Betrieb des elektrischen Energiespeichers innerhalb eines vorgegebenen Spannungsbereiches.

Ausführung der Erfindung

Bei der in Fig. 1 links dargestellten Schaltung eines Tiefsetzstellers für einen elektrischen Energiespeicher 1 liegt außen eine Netzspannung $u_N$ an, wobei in Serie eine Spule $L_N$ mit einem Innenwiderstand $R_N$ und ein Zwischenkreiskondensator $C_D$ geschaltet sind, wobei die Spule $L_N$ und der Innenwiderstand $R_N$ eine Netzdrossel bilden. Parallel zum Zwischenkreiskondensator $C_D$ liegt der aktive Zwischenkreisschutz AZS zum Schutz des Zwischenkreises gegen mögliche Überspannungen, welcher aus der Serienschaltung eines Schalters mit einem AZS-Widerstand besteht.
Mit Hilfe eines getakteten Schalters S wird der elektrische Energiespeicher geladen, wobei die Spule $L_{ES}$ mit dem Innenwiderstand $R_{LES}$ eine Energiespeicherdrossel sowie der Kondensator $C_{ES}$ mit dem Innenwiderstand $R_{ES}$ den elektrischen Energiespeicher 1 bilden.
Hierbei liegt am Energiespeicher 1 eine Energiespeicherspannung $u_{ES}$ an, welche eine minimale $U_{ES,\min}$ und eine maximale Energiespeicherspannung $U_{ES,\max}$ nicht unterschreiten bzw. überschreiten darf.
Durch die erfindungsgemäße Art der dynamischen Begrenzung wird sichergestellt, dass die minimal $U_{ES,\min}$ bzw. maximal zulässige Energiespeicherspannung $U_{ES,\max}$ eingehalten werden und so der Schutz des Energiespeichers 1 gewährleistet wird. Die Regelung bewirkt eine dynamische Eingrenzung des minimalen bzw. maximalen Sollladestroms $I_{ES,soll}$ und verhindert somit ein Überladen oder ein übermäßiges Entladen des Energiespeichers 1.
Diese Regelung bewirkt im Vergleich zur Steuerung, dass der Energiespeicher im Bereich der minimal $U_{ES,\min}$ bzw. maximal zulässigen Energiespeicherspannung $U_{ES,\max}$ nur mehr moderat entladen bzw. geladen wird, wodurch abrupte Sollstromänderungen vermieden werden, wenn die minimal $U_{ES,\min}$ oder maximal zulässige Energiespeicherspannung $U_{ES,\max}$ erreicht wird.
Konkret wird beim erfindungsgemäßen Verfahren laufend die Energiespeicherspannung $u_{ES}$ mit einer hier nicht dargestellten Messeinrichtung gemessen und daraus werden gemäß den Gleichungen 2 und 3 die Werte für $I_{ES,\max,akt}$ und $I_{ES,\min,akt}$ berechnet. Der dem Energiespeicher 1 zugeführte (bzw. entnommene) Strom $I_{ES}$ wird dabei so eingestellt, dass Gleichung 1 erfüllt ist, also der Strom $I_{ES}$ größer gleich $I_{ES,\min,akt}$ und kleiner gleich $I_{ES,\max,akt}$ gehalten wird. Um den Sollenergiespeicherstrom $I_{ES,soll}$ entsprechend führen zu können, wird das Tastverhältnis des getakteten Schalters S entsprechend eingestellt. Das Tastverhältnis ist das Verhältnis der Einschaltdauer des Schalters (Schalterstellung S = 1) zur Periodendauer des Schaltzyklus. Typische Taktfrequenzen des Schalters S liegen bei 1kHz.

Bezugszeichenliste:

| | |
|---|---|
| 1 | Energiespeicher |
| AZS | Aktiver Zwischenkreisschutz |
| $u_N$ | Netzspannung |
| $u_D$ | Zwischenkreisspannung |
| $u_{ES}$ | Energiespeicherspannung |
| $L_N$ | Spule der Netzdrossel |
| $R_N$ | Innenwiderstand der Netzdrossel |
| $C_D$ | Zwischenkreiskondensator |
| S | Schalter |
| $L_{ES}$ | Induktivität der Energiespeicherdrossel |
| $R_{LES}$ | Innenwiderstand der Energiespeicherdrossel |
| $C_{ES}$ | Kapazität eines elektrischen Energiespeichers 1 |
| $R_{ES}$ | Innenwiderstand des elektrischen Energiespeichers 1 |
| $U_{ES}$ | (aktuelle) Energiespeicherspannung |
| $U_{ES,min}$ | minimal zulässige Energiespeicherspannung |
| $U_{ES,max}$ | maximal zulässige Energiespeicherspannung |
| $I_{ES,min}$ | minimal zulässiger Energiespeicherstrom |
| $I_{Es,max}$ | maximal zulässiger Energiespeicherstrom |
| $I_{ES,soll}$ | Sollenergiespeicherstrom |
| $I_{ES,offset}$ | konstanter Offsetstrom |

**Patentansprüche**

**1.** Verfahren zum sicheren Betrieb eines elektrischen Energiespeichers (1), gebildet aus einem Kondensator $C_{ES}$ mit einem Innenwiderstand $R_{ES}$, innerhalb eines vorgegebenen Spannungsbereiches mit einer minimalen und einer maximalen Energiespeicherspannung $U_{ES,min}$, $U_{ES,max}$, **dadurch gekennzeichnet, dass**

- bei Annäherung an die vorgegebene minimale oder maximale Energiespeicherspannung $U_{ES,min}$, $U_{ES,max}$ des elektrischen Energiespeichers (1) ein Sollenergiespeicherstrom $I_{ES,soll}$ in Abhängigkeit einer aktuellen Energiespeicherspannung $U_{ES}$ durch einen aktuell minimalen und einen aktuell maximalen Energiespeicherstrom $I_{ES,min,akt}$, $I_{ES,max,akt}$ begrenzt wird, wobei
- für die Berechnung des aktuell minimalen Energiespeicherstroms $I_{ES,min,akt}$ eine Differenz zwischen der minimalen Energiespeicherspannung $U_{ES,min}$ und der aktuellen Energiespeicherspannung $U_{ES}$ gebildet wird, und/oder für die Berechnung des aktuell maximalen Energiespeicherstroms $I_{ES,max,akt}$ eine Differenz zwischen der maximalen Energiespeicherspannung $U_{ES,max}$ und der aktuellen Energiespeicherspannung $U_{ES}$ gebildet wird, und wobei
- der aktuell minimale Energiespeicherstrom $I_{ES,min,akt}$ durch Multiplikation des Differenzwerts ($U_{ES,min}$ - $U_{ES}$) mit einem konstanten Faktor $k_2$ und Subtraktion eines konstanten Offsetstroms $I_{ES,offset}$ vom Produkt gebildet wird, und der aktuell maximale Energiespeicherstrom $I_{ES,max,akt}$ durch Multiplikation des Differenzwerts ($U_{ES,max}$ - $U_{ES}$) mit einem konstanten Faktor $k_1$ und Addition des konstanten Offsetstroms $I_{ES,offset}$ zum Produkt gebildet wird.

**2.** Verfahren nach Anspruch 1, **dadurch gekennzeichnet, dass** der aktuell maximale Energiespeicherstrom $I_{ES,max,akt}$ und der aktuell minimale Energiespeicherstrom ($I_{ES,min,akt}$) wie folgt bestimmt werden:

$$I_{ES,max,akt} = \min\{I_{ES,max};\ k_1 * (U_{ES,max} - U_{ES}) + I_{ES,offset}\},$$

$$I_{ES,min,akt} = \max\{-I_{ES,max};\ k_2 * (U_{ES,min} - U_{ES}) - I_{ES,offset}\},$$

wobei $I_{ES,MAX}$ den maximal zulässigen Energiespeicherstrom darstellt.

3. Verfahren nach Anspruch 2, **dadurch gekennzeichnet, dass** der konstante Offsetstroms $I_{ES,offset}$ 2-8% des maximal zulässigen Energiespeicherstroms $I_{Es,max}$ beträgt.

4. Verfahren nach Anspruch 2 oder 3, **dadurch gekennzeichnet, dass** bei Erreichen der minimalen oder der maximalen Energiespeicherspannung $U_{ES,min}$, $U_{ES,max}$ der Energiespeicher mit dem konstanten positiven Offsetstrom $I_{ES,offset}$ entladen oder geladen wird.

5. Verfahren nach einem der Ansprüche 1 bis 4, **dadurch gekennzeichnet, dass** bei der Entladung des Energiespeichers (1) unter die minimale Energiespeicherspannung $U_{ES,min}$ oder bei der Überladung des Energiespeichers (1) über die maximale Energiespeicherspannung $U_{ES,max}$ der Offsetstrom $I_{ES,offset}$ auf Null abgebaut wird.

6. Verfahren nach einem der Ansprüche 1 bis 5, **dadurch gekennzeichnet, dass** durch die konstanten Faktoren $k_1$, $k_2$ jene Energiespeicherspannung $U_{ES}$ für den Beginn der Einschleifregelung entsprechend der Differenzwerte $(U_{ES,min} - U_{ES})$ bzw. $(U_{ES,max} - U_{ES})$ festgelegt wird.

7. Verfahren nach Anspruch 6, **dadurch gekennzeichnet, dass** die Einschleifregelung bei Annäherung an die maximale Energiespeicherspannung $U_{ES,max}$ beginnt, wenn die Energiespeicherspannung $U_{ES}$ gleich einer Start-Energiespeicherspannung $U_{ES,StartBeg1}$ ist, wobei der konstante Faktor $k_1$ derart berechnet wird:

$$k_1 = \frac{I_{ES,\max} - I_{ES,offset}}{U_{ES,\max} - U_{ES,StartBeg1}} \cdot$$

8. Verfahren nach Anspruch 6 oder 7, **dadurch gekennzeichnet, dass** die Einschleifregelung bei Annäherung an die minimale Energiespeicherspannung $U_{ES,min}$ beginnt, wenn die Energiespeicherspannung $U_{ES}$ gleich einer Start-Energiespeicherspannung $U_{ES,startBeg2}$ ist, wobei der konstante Faktor $k_2$ derart berechnet wird:

$$k_2 = \frac{I_{ES,offset} - I_{ES,\max}}{U_{ES,\min} - U_{ES,StartBeg2}} \cdot$$

9. Verfahren nach Anspruch 8, **dadurch gekennzeichnet, dass** die Start-Energiespeicherspannung $U_{ES,StartBeg1}$ gleich 95-99% der maximalen Energiespeicherspannung $U_{ES,max}$ gesetzt wird.

10. Verfahren nach Anspruch 9, **dadurch gekennzeichnet, dass** die Start-Energiespeicherspannung $U_{ES,startBeg2}$ gleich 101-105% der minimalen Energiespeicherspannung $U_{ES,min}$ gesetzt wird.

**Claims**

1. Method for reliable operation of an electric energy store (1), formed by a capacitor $C_{ES}$ with an internal resistance $R_{ES}$, within a predefined voltage range with a minimum and a maximum energy store voltage $U_{ES,min}$, $U_{ES,max}$, **characterised in that**

- when approaching the predefined minimum or maximum energy store voltage $U_{ES,min}$, $U_{ES,max}$ of the electric energy store (1), a target energy store current $I_{ES,tar}$ is delimited as a function of a current energy store voltage $U_{ES}$ by a current minimum and a current maximum energy store current $I_{ES,min,cur}$, $I_{ES,max,cur}$, wherein
- for calculating the current minimum energy store current $I_{ES,min,cur}$ a difference between the minimum energy store voltage $U_{ES,min}$ and the current energy store voltage $U_{ES}$ is formed, and/or for calculating the current maximum energy store current $I_{ES,max,cur}$ a difference between the maximum energy store voltage $U_{ES,max}$ and the current energy store voltage $U_{ES}$ is formed, and wherein
- the current minimum energy store current $I_{ES,min,cur}$ is formed by multiplying the difference value $(U_{ES,min} - U_{ES})$ by a constant factor $k_2$ and subtracting a constant offset current $I_{ES,offset}$ from the product, and the current maximum energy store current $I_{ES,max,cur}$ is formed by multiplying the difference value $(U_{ES,max} - U_{ES})$ by a

constant factor $k_1$ and adding the constant offset current $I_{ES,offset}$ to the product.

2. Method according to claim 1, **characterised in that** the current maximum energy store current $I_{ES,max,cur}$ and the current minimum energy store current ($I_{ES,min,cur}$) are determined as follows:

$$I_{ES,max,cur} = min(I_{ES,max}; \ k_1 \ * \ (U_{ES,max} - U_{ES}) \ + \ I_{ES,offset}),$$

$$I_{ES,min,cur} = max(I_{ES,max}; \ k_2 \ * \ (U_{ES,min} - U_{ES}) \ - \ I_{ES,offset}),$$

wherein $I_{Es,max}$ represents the maximum permitted energy store current.

3. Method according to claim 2, **characterised in that** the constant offset current $I_{ES,offset}$ amounts to 2-8% of the maximum permitted energy store current $I_{ES,MAX}$.

4. Method according to claim 2 or 3, **characterised in that** when the minimum or maximum energy store voltage $U_{ES,min}$, $U_{ES,max}$ is reached, the energy store is discharged or charged with the constant positive offset current $I_{ES,offset}$.

5. Method according to one of claims 1 to 4, **characterised in that** when discharging the energy store (1) below the minimum energy store voltage $U_{ES,min}$, or when overcharging the energy store (1) above the maximum energy store voltage $U_{ES,max}$, the offset current $I_{ES,offset}$ is reduced to zero.

6. Method according to one of claims 1 to 5, **characterised in that** the constant factors $k_1$, $k_2$ stipulate the energy store voltage $U_{ES}$ for the beginning of the loop-in regulation according to the difference values ($U_{ES,min} - U_{ES}$) or ($U_{ES,max} - U_{ES}$).

7. Method according to claim 6, **characterised in that** the loop-in regulation begins, when approaching the maximum energy store voltage $U_{ES,max}$, when the energy store voltage $U_{ES}$ is equal to a starting energy store voltage $U_{ES,startBeg1}$, wherein the constant factor $k_1$ is calculated such that:

$$k_1 = \frac{I_{ES,max} - I_{ES,offset}}{U_{ES,max} - U_{ES,StartBeg1}}.$$

8. Method according to claim 6 or 7, **characterised in that** the loop-in regulation begins, when approaching the minimum energy store voltage $U_{ES,min}$, when the energy store voltage $U_{ES}$ is equal to a starting energy store voltage $U_{ES,startBeg2}$, wherein the constant factor $k_2$ is calculated such that:

$$k_2 = \frac{I_{ES,offset} - I_{ES,max}}{U_{ES,min} - U_{ES,StartBeg2}}.$$

9. Method according to claim 8, **characterised in that** the starting energy store voltage $U_{ES,startBeg1}$ is equated to 95-99% of the maximum energy store voltage $U_{ES,max}$.

10. Method according to claim 9, **characterised in that** the starting energy store voltage $U_{ES,startBeg2}$ is equated to 101-105% of the minimum energy store voltage $U_{ES,min}$.

**Revendications**

1. Procédé pour le fonctionnement en toute sécurité d'un accumulateur d'énergie électrique (1), formé par un condensateur $C_{ES}$ avec une résistance interne $R_{ES}$, dans une plage de tension donnée avec une tension d'accumulation d'énergie minimale et une tension d'accumulation d'énergie maximale $U_{ES,min}$, $U_{ES,max}$, **caractérisé en ce que**

- à l'approche de la tension d'accumulation d'énergie minimale ou maximale donnée $U_{ES,min}$, $U_{ES,max}$ de l'accumulateur d'énergie électrique (1), un courant d'accumulateur d'énergie de consigne $I_{ES,soll}$ est limité en fonction d'une tension d'accumulation d'énergie actuelle $U_{ES}$ par un courant d'accumulateur d'énergie minimal actuel et un courant d'accumulateur d'énergie maximal actuel $I_{ES,min,akt}$, $I_{ES,max,akt}$,
- pour le calcul du courant d'accumulateur d'énergie minimal actuel $I_{ES,min,akt}$ étant formée une différence entre la tension d'accumulation d'énergie minimale $U_{ES,min}$ et la tension d'accumulation d'énergie actuelle $U_{ES}$ et/ou pour le calcul du courant d'accumulateur d'énergie maximal actuel $I_{ES,max,akt}$ étant formée une différence entre la tension d'accumulation d'énergie maximale $U_{ES,max}$ et la tension d'accumulation d'énergie actuelle $U_{ES}$ et
- le courant d'accumulateur d'énergie minimal actuel $I_{ES,min,akt}$ étant formé par multiplication de la valeur de différence $(U_{ES,min} - U_{ES})$ par un facteur constant $k_2$ et soustraction d'un courant d'offset constant $I_{ES,offset}$ du produit, et le courant d'accumulateur d'énergie maximal actuel $I_{ES,max,akt}$ étant formé par multiplication de la valeur de différence $(U_{ES,max} - U_{ES})$ par un facteur constant $k_1$ et addition du courant d'offset constant $I_{ES,offset}$ au produit.

2. Procédé selon la revendication 1, **caractérisé en ce que** le courant d'accumulateur d'énergie maximal actuel $I_{ES,max,akt}$ et le courant d'accumulateur d'énergie minimal actuel $(I_{ES,min, akt})$ sont déterminés comme suit :

$$I_{ES,max, akt} = \min\{I_{ES,max} \;;\; k_1 * (U_{ES,max} - U_{ES}) + I_{ES,offset}\},$$

$$I_{ES,min,akt} = \max\{-I_{ES,max} \;;\; k_2 * (U_{ES,min} - U_{ES}) - I_{ES,offset}\},$$

$I_{ES,MAX}$ représentant le courant d'accumulateur d'énergie maximal autorisé.

3. Procédé selon la revendication 2, **caractérisé en ce que** le courant d'offset constant $I_{ES,offset}$ représente 2 à 8 % du courant d'accumulateur d'énergie maximal autorisé $I_{ES,MAX}$.

4. Procédé selon la revendication 2 ou 3, **caractérisé en ce que**, à l'obtention de la tension d'accumulation d'énergie minimale ou maximale $U_{ES,min}$, $U_{ES,max}$, l'accumulateur d'énergie est déchargé ou chargé avec le courant d'offset positif constant $I_{ES,offset}$.

5. Procédé selon l'une des revendications 1 à 4, **caractérisé en ce que**, lorsque la charge de l'accumulateur d'énergie (1) tombe en dessous de la tension d'accumulation d'énergie minimale $U_{ES,min}$ ou lorsque la charge de l'accumulateur d'énergie (1) dépasse la tension d'accumulation d'énergie maximale $U_{ES,max}$, le courant d'offset $I_{ES,offset}$ est ramené à zéro.

6. Procédé selon l'une des revendications 1 à 5, **caractérisé en ce que** les facteurs constants $k_1$, $k_2$ déterminent la tension d'accumulation d'énergie $U_{ES}$ pour le début du réglage d'intégration conformément aux valeurs de différence $(U_{ES,min} - U_{ES})$ resp. $(U_{ES,max} - U_{ES})$.

7. Procédé selon la revendication 6, **caractérisé en ce que** le réglage d'intégration commence à l'approche de la tension d'accumulation d'énergie maximale $U_{ES,max}$ si la tension d'accumulation d'énergie $U_{ES}$ est égale à une tension d'accumulation d'énergie de démarrage $U_{ES,StartBeg1}$, le facteur constant $k_1$ étant calculé comme suit :

$$k_1 = \frac{I_{ES,\max} - I_{ES,offset}}{U_{ES,\max} - U_{ES,StartBeg1}} \; .$$

8. Procédé selon la revendication 6 ou 7, **caractérisé en ce que** le réglage d'intégration commence à l'approche de la tension d'accumulation d'énergie minimale $U_{ES,min}$ si la tension d'accumulation d'énergie $U_{ES}$ est égale à une tension d'accumulation d'énergie de démarrage $U_{ES,startBeg2}$, le facteur constant $k_2$ étant calculé comme suit :

$$k_2 = \frac{I_{ES,offset} - I_{ES,max}}{U_{ES,min} - U_{ES,StartBeg\,2}} \cdot$$

**9.** Procédé selon la revendication 8, **caractérisé en ce que** la tension d'accumulation d'énergie de démarrage $U_{ES,StartBeg1}$ est rendue égale à 95 à 99 % de la tension d'accumulation d'énergie maximale $U_{ES,max}$.

**10.** Procédé selon la revendication 9, **caractérisé en ce que** la tension d'accumulation d'énergie de démarrage $U_{ES,startBeg2}$ est rendue égale à 101 à 105% de la tension d'accumulation d'énergie minimale $U_{ES,min}$.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20100259210 A1